Europäisches Patentamt

European Patent Office

Office européen des brevets

(11) Publication number: **0 308 726**
A2

# EUROPEAN PATENT APPLICATION

(21) Application number: 88114614.6

(51) Int. Cl.⁴: **H01L 27/02**

(22) Date of filing: 07.09.88

(30) Priority: 24.09.87 JP 237133/87
22.08.88 JP 206309/88

(43) Date of publication of application:
29.03.89 Bulletin 89/13

(84) Designated Contracting States:
DE FR GB

(71) Applicant: **HITACHI, LTD.**
6, Kanda Surugadai 4-chome Chiyoda-ku
Tokyo(JP)

(72) Inventor: **Masaki, Akira**
**1-1-14, Kitamachi Kichijouji**
**Musashino-shi Tokyo(JP)**
Inventor: **Yasunaga, Moritoshi**
**2-5-13, Totsuka**
**Kawaguchi-shi, Saitama-ken(JP)**
Inventor: **Mizuishi, Kenichi**
**2-19-13, Nanyoudai**
**Hachiouji-shi Tokyo(JP)**
Inventor: **Mukai, Kiichiro**
**2-24-14, Akatsuki-cho**
**Hachiouji-shi Tokyo(JP)**
Inventor: **Itoh, Hiroyuki**
**A3-2, Suzukishinden-shataku 1473,**
**Jousuihon-cho**
**Kodaira-shi Tokyo(JP)**

(74) Representative: **Patentanwälte Beetz sen. -**
**Beetz jun. Timpe - Siegfried -**
**Schmitt-Fumian- Mayr**
**Steinsdorfstrasse 10**
**D-8000 München 22(DE)**

(54) Wafer scale integrated circuit.

(57) A wafer scale integrated circuit wherein at least one of a plurality of functional blocks (2) formed on a semiconductor wafer (1) has its internal defects repaired and has an area which is at least 2.3 cm². The integrated circuit permits the use of a functional block having an area that is much greater than that of the conventional blocks. Therefore, the total length of wirings among the blocks can be shortened to simplify the complex wiring process, the total number of wiring layers can be reduced, and the signal propagation delay time can be shortened, too, making it possible to realize a high packaging density with low redundancy.

FIG. 1

## WAFER SCALE INTEGRATED CIRCUIT

Background of the Invention

The present invention relates to an integrated circuit, and more particularly to a so-called wafer scale integrated circuit.

A monolithic wafer scale integrated circuit generally stands for an integrated circuit in which a plurality of functional blocks formed on a semiconductor wafers are not individually taken out by dicing or a like method but are permitted to operate in the form of a wafer. Further, integrated circuit chips stand for the individual functional blocks that are formed on a wafer and are individually taken out by dicing or a like method. Moreover, a hybrid wafer scale integrated circuit stands for an integrated circuit in which a substrate consists of a semiconductor water on which are formed wirings only or wirings and elements, and in which a semiconductor integrated circuit chip is mounted on the wafer and is electrically connected thereto.

In this specification, the wafer scale integrated circuit stands for both the monolithic wafer scale integrated circuit and a hybrid wafer scale integrated circuit.

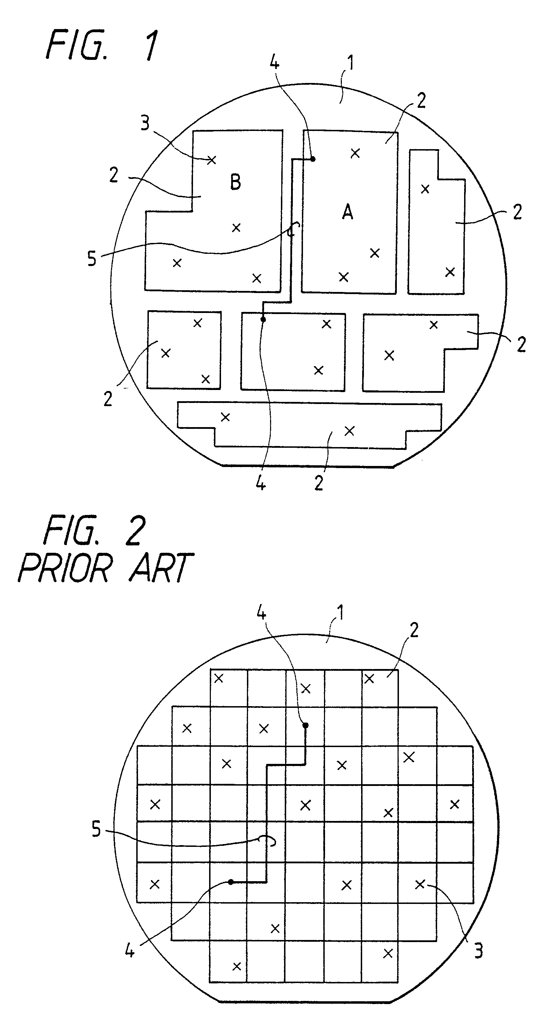

Prior art related to the wafer scale integrated circuit has been discussed in Yamashita, Kanasugi, Tsuchiya, Goto, "Probability and Limit of Wafer Scale LSI", Nikkei Electronics, No. 422, June 1, 1987, pp. 141-161. According to the above prior art as generally shown in Fig. 2, a plurality of functional blocks 2 of almost equal integration level are formed on a wafer 1, the integration scale of each of the blocks being selected to be nearly that of an LSI chip that is fabricated by an ordinary semiconductor fabrication technology, and malfunctioning blocks that contain defect 3 are not used but good blocks only are used, the input-output signal terminals 4 thereof are globally wired, as required, through a wiring 5, so that the wafer scale integrated circuit as a whole exhibits its functions. The wafer scale integrated circuit which as a whole is formed in a single semiconductor wafer is called monolithic wafer scale integrated circuit as mentioned above.

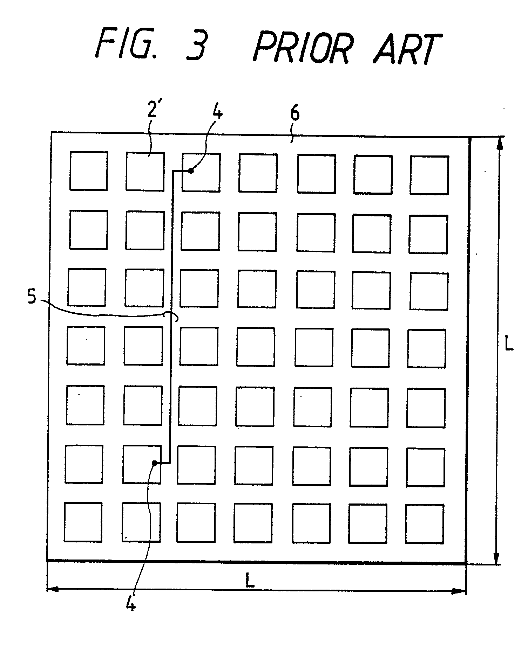

Referring to Fig. 3, furthermore, a semiconductor wafer 6 works chiefly as a wiring substrate, the individual blocks 2' are formed as separate blocks, and good chips only are connected to the wiring substrate wafer. This device is called hybrid wafer scale integrated circuit as mentioned earlier.

In designing a computer logic, a large computer must have a logic scale which is greater than that of the conventional LSI's. When a conventional hybrid wafer scale integrated circuit technology is to be employed, for example, the whole logic is divided into a number of blocks 2' as shown in Fig. 3. In this case, one block corresponds to one chip. When the logic is to be divided as described above, it has been known that there holds an empirical rule called Rent's rule expressed by the following equation (1) between the integration scale represented by a gate number G of the blocks and a number P of the input-output signal terminals 4, i.e.,

$$P = a \cdot G^r \qquad (1)$$

where a and r are constants that are determined depending upon the logic structure, i.e., a is 2 to 3 and r is 1/2 to 2/3 in an ordinary computer logic.

Over a range in which this rule holds true, therefore, a relatively large number of input/output signal terminals must be taken out from each of the blocks. For example, an LSI having about 3000 gates must have about 200 to 300 input-output signal terminals. Therefore, a wiring substrate 6 for mounting these blocks must accommodate a number of wirings 5 for connection among the blocks and, hence, requires a high degree of wiring process. A total length W of wiring on the wiring substrate is given, for example, by the following equation (2).

$$W = \frac{2(1-r)}{2r-1} \cdot (B^{r-\frac{1}{2}} - 1) \cdot LB^{\frac{1}{2}} P \cdot \frac{N-1}{N} \qquad ---- \quad (2)$$

where r is the same as r of the equation (1), B denotes a number of blocks on the wiring substrate, L denotes the length of a side of a square wiring substrate, P is the same as P of the equation (1), and N is an average number of the input-output signal terminals of a block that are contained in a single signal net on the wiring substrate or that are connected to one continuous wiring 5, and which average number in this case may be, for example, about 3.

As described above, the greatest factor which imposes limitation on the integration scale of LSI is that the yield $\eta$ of the LSI chip conspicuously decreases with increase in the chip area as given by the following equation (3),

$$\eta = \exp(-\lambda A) \qquad (3)$$

where A denotes a chip area (cm$^2$) and $\lambda$ denotes a defect density (cm$^{-2}$).

The value $\lambda$ varies depending upon the conditions and may, in one example, be 1 to 3 per a square centimeter. Therefore, it is not easy to economically prepare a chip having a side which is greater than about 1.5 centimeters.

That is, even when the defect density $\lambda$ is 1 (cm$^{-2}$), the yield $\eta$ is 0.105 if the chip area A = 1.5$^2$(cm$^2$) (i.e., about 2.3 cm$^2$) and $\lambda$ = 1 are substituted for the above equation (3); i.e., the yield of chips having a side of 1.5 cm is as low as about 10%. The yield which is smaller than 10% is far from practicable.

In the foregoing were described the number P of input-output terminals, the total length W of wirings and yield $\eta$ of chips with reference to the case of a hybrid wafer scale integrated circuit. If the above chip is called functional block, then the above description can be directly applied to the monolithic wafer scale integrated circuit. In the following description, therefore, the functional block includes a semiconductor integrated circuit chip.

In the conventional wafer scale integrated circuit, the integration degree of the blocks is so selected that a sufficiently high yield is obtained in compliance with the equation (3) irrespective of whether it is a monolithic wafer scale integrated circuit or a hybrid wafer scale integrated circuit. When applied to the logic of a large computer or the like, therefore, large amount of wirings derived from the equations (1) and (2) must be formed on the wafers giving rise to the occurrence of a serious defect in the wiring process.

In the conventional monolithic wafer scale integrated circuit, in particular, a relatively high packaging density is not achieved as expected. This is because, if a system having a very high terminal density is used as the connection technique, e.g., if a system of solder bumps (which is discussed on page 150 of the aforementioned literature) is used as a connection method for the hybrid wafer scale integrated circuit, it becomes possible to mount any necessary number of chips on the wiring substrate wafer without almost increasing the area of the chip or the area among the chips. In the conventional monolithic wafer scale integrated circuit as shown in Fig. 2, however, even those blocks that have defects 3 and that do not properly work are contained in the total area of the wafer scale integrated circuit, causing the packaging efficiency to decrease as a whole. With the conventional monolithic wafer scale integrated circuit, therefore, the packaging density becomes smaller than that of the hybrid wafer scale integrated circuit depending upon the conditions.

According to the prior art, furthermore, it is not allowed to increase the integration scale of the functional block, and a path through which signals propagate crosses over several functional blocks. Therefore; the delay times that develop among the functional blocks occupy a very large proportion among the delay times in the whole path. Therefore, even if the delay time is greatly reduced in the functional blocks, the resultant effect for reducing the delay time is not so conspicuous. For example, the GaAs LSI has an integration scale which is usually smaller than that of the silicon LSI. Because of the aforementioned reasons, therefore, the delay time increases between the LSI's no matter how fast als are propagated in the LSI's. Namely, the high-speed operation is not accomplished even if GaAs is used but rather the operation speed becomes lower than that of when silicon is used.

Summary of the Invention

The object of the present invention is to provide a wafer scale integrated circuit in which functional blocks of large areas obtained maintaining a high yield are provided on a semiconductor wafer, and the total length of wirings among the functional blocks is shortened, as well as to provide a wafer scale integrated circuit which shortens the signal propagation delay time among the functional blocks, and which has a small redundancy and a high packaging density, overcoming the aforementioned difficulties inherent in the prior art.

According to the wafer scale integrated circuit of the present invention which achieves the above-mentioned object, at least one of a plurality of functional blocks constituting the wafer scale integrated circuit has an area that is greater than 2.3 cm$^2$ and the defect in the block is repaired. In other words, according to the present invention, at least one functional block is repaired for its defect among a plurality of functional blocks that constitute the wafer scale integrated circuit, and, furthermore, the above-mentioned block has such a large integration scale (i.e., has an area of greater than 2.3 cm$^2$) that a practical yield can be obtained only by repairing the defect.

The above practical yield stands for at least about 10%. The functional blocks may be repaired using a widely known method of repairing the integrated circuits. An example of the method will be discussed in the embodiment 3 mentioned later. The yield according to the present invention can, in practice, be increased to greater than 90%.

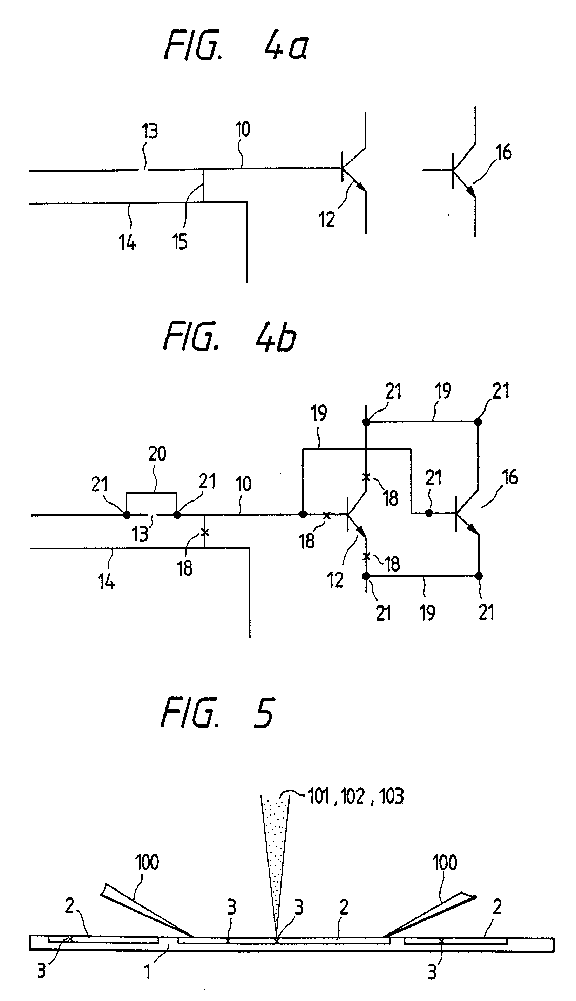

The above functional block whose defect is repaired has i) a cut-away portion in the wiring provided between the insulating layers, and/or ii) an additional wiring portion that connects to a wiring provided between the insulating layers via a hole formed in the insulating layer on the wiring. The additional wiring can be composed of, for example, tungsten or molybdenum. Furthermore, an element (e.g., defective element indicated by numeral 12 in Fig. 4) whose wiring is cut, in many cases, is left in the functional block whose defect is repaired.

The wafer scale integrated circuit according to the present invention can be fabricated according to the following process which comprises:

i) a step for forming a plurality of functional blocks (at least one of them has an area of greater than 2.3 cm$^2$) on a semiconductor wafer;

ii) a step for inspecting a functional block that has an area of greater than 2.3 cm$^2$ to discover breakage in the wiring, short circuit among the wirings and defective elements;

iii) a step for rewiring broken portion in the wiring, for cutting the short-circuited portions among the wirings, and/or rewiring to replace defective elements by good spare elements; and

iv) effecting the wiring among the functional blocks.

The inspection and/or repairing may be effected after the above step iv) has been finished.

Brief Description of the Drawings:

Fig. 1 is a plan view for explaining a wafer scale integrated circuit according to an embodiment of the present invention;

Figs. 2 and 3 are plan views for explaining the wafer scale integrated circuits according to the prior art;

Fig. 4a is a diagram illustrating the wiring condition of a functional block before repaired in the wafer scale integrated circuit according to an embodiment of the present invention;

Fig. 4b is a diagram illustrating the wiring condition of a functional block after being repaired in the wafer scale integrated circuit according to an embodiment of the present invention;

Fig. 5 is a section view for schematically illustrating a method of inspecting and repairing the functional blocks in the wafer scale integrated circuit according to an embodiment of the present invention;

Fig. 6 is a section view illustrating a wiring portion that is cut for repairing a functional block in the wafer scale integrated circuit according to an embodiment of the present invention;

Figs. 7a and 7b are section views illustrating the steps for rewiring in a functional block in the wafer scale integrated circuit to replace defective elements by good elements according to an embodiment of the present invention;

Fig. 8 is a plan view for explaining a functional block (semiconductor integrated circuit chip) in the wafer scale integrated circuit according to another embodiment of the present invention;

Fig. 9 is a section view which schematically illustrates a wafer scale integrated circuit (hybrid type) according to another embodiment of the present invention;

Figs. 10a and 10b are diagrams for schematically explaining signal paths in the wafer scale integrated circuit according to prior art;

Fig. 10c is a diagram which schematically explains a signal path in the wafer scale integrated circuit according to a still further embodiment of the present invention;

Fig. 11 is a diagram for explaining the condition of signal delay times in the wafer scale integrated circuits according to the prior art and the present invention; and

Fig. 12 is a graph illustrating a relationship between the replacement unit size and the redundancy in the wafer scale integrated circuit.

Description of the Preferred Embodiments

According to the present invention, the logic function is inspected for each of the blocks to find the position of defect, the defective portion is cut away, and a spare element and a circuit that have been provided in advance are connected in its place in order to obtain a good block. The above method makes it possible to realize a block having an area (at least 2.3 cm² such as 5 cm² or 10 cm²) which is much greater than a limit determined by the equation (3).

Even with the computer of the above-mentioned type, the number of input-output signal terminals can be decreased to be much smaller than the number that is given by the equation (1) for which the values a and r are substituted, provided the logic is divided in a size large enough for each block to form a logically desirable unit.

The system to be constituted by the integrated circuit is a set of macro functions such as arithmetic units and register groups. The numbers of input-output terminals of these functional blocks may be smaller than the number of input-output terminals that is derived from Rent's rule expressed by the equation (1) described earlier. Rent's rule is an empirical rule that holds true when these functional blocks are logically divided into small groups of functional blocks. Therefore, when the arithmetic units and register groups are used as functional blocks without being divided, they need have input-output terminals in a number smaller than the number of input-output terminals derived according to Rent's rule. For example, an arithmetic unit of fixed decimal point with 100,000 gates has about 1000 input-output terminals. Referring to the equation (1) of Rent's rule, if a = 2 and r = 2/3, then the number of input-output terminals is about 4,300 when G = 100,000. In practice, therefore, the number needs be one-fourth thereof. This is because the partition of logic causes the divided functional blocks to lose unity, and an increased number of input-output terminals are needed due to mutual wiring among the divided functional blocks.

This function will be described quantitatively by referring an example. In constituting a computer logic with 500,000 gates using a conventional wafer scale integrated circuit, if the gate number G which represents the integration level of each of the blocks is 10000 gates, then P = 928 provided a = 2 and r = 2/3 in the equation (1). When these blocks are formed on a square wafer having a side of 10 cm, the wiring length W becomes 804 m if L = 10 cm, B = 50 and N = 3 in the equation (2). If the wirings can be formed on the wafer maintaining an average pitch of 50 μm, then the wiring length that can be accommodated by each layer is 200 m. If 50% of the wiring is used, then about eight wiring layers are necessary for even propagating the signals only. Further, if each block is a square having a side of 1 cm, the yield $\eta$ is as small as 37% even when $\lambda$ is one per square centimer in the equation (2). With the conventional monolithic wafer scale integrated circuit, therefore, there are obtained only 37 good blocks in average even when 100 blocks are formed on a square wafer having a side of 10 cm without leaving any gap, on which it is not possible to mount the whole computer logic having 500,000 gates that was mentioned above.

According to the present invention, on the other hand, the block scale can be selected to be of such a size that is capable of completely accommodating the macro function, i.e., can be selected to have about 50,000 gates, and the input-output signal terminals of each block can be limited to be about 1000. In this case, the wiring length W can be reduced to 197 m if r = 2/3, L = 10 cm, B = 10 and N = 3 in the equation (2). Therefore, if the wiring can be formed on the wafer maintaining an average pitch of 50 μm, then the wiring length that can be accommodated by one layer is 200 m. If 50% of the wiring is used, only two wiring layers are necessary for propagating the signals. Further, each block has a size of 5 cm². In this case, there will be contained an average of 5 defects that should be repaired in the case when $\lambda$ is one per square centimeter.

Next, described below is the delay time in the case of the macro function mentioned above. It is presumed that the integration level of each block on a silicon wafer is 10,000 gates, and a signal path constituted by, for example, the gates of 20 stages crosses the block three times. In this case, if the delay time of the whole signal path is 20 ns, then the delay time in the block is about 14 ns, and the remaining delay time of 6 ns stems from the input-output buffer circuit or wiring among the blocks caused by the crossover of three times between blocks.

Here, when it is attempted to use, for example, GaAs instead of silicon in order to increase the speed, then each block must have a size which is smaller than 10,000 gates. This is because, when GaAs is used, the defect density usually becomes greater than that of when silicon is used. When the yield (37%) is the same as that of the aforementioned silicon block, the integration level of the block becomes 2000 gates if the defect density of GaAs is 5/cm² which is five times as great as that of silicon. In this case, the signal path crosses the blocks six times. Here, the number of crossovers is determined by the number of stages of gates in the block that varies depending upon the integration level of the block. When the integration

5

levels of the blocks are 2000, 10000 and 50000 gates, the number of stages of gates in the block become 3.5, 7.5 and 21 stages repectively. Therefore, the signal path of 20 stages crosses over 6 times, 3 times and 0 time in their respective cases. Therefore, when the block has 2000 gates, the delay time that stems from crossing over the block becomes twice as great, i.e., 12 ns. On the other hand, the delay time in the block is reduced to one-half owing to the use of GaAs, i.e., reduced to 7 ns. Therefore, the delay time is 19 ns throughout the entire path, and the effect for high-speed operation is very small compared with the delay time of 20 ns of when silicon is used.

According to the present invention, on the other hand, a block is realized having about 50,000 gates. With this integration scale, the aforementioned signal path is entirely contained in a single block as described above. Therefore, there no longer exists the delay time of 6 ns that stems from the crossover between blocks, and there exists the delay time of 14 ns only that stems from the block.

When GaAs is used, furthermore, the delay time in the block is halved, and the delay time is reduced to 7 ns throughout the entire path. Therefore, the present invention makes it possible to reduce both the delay time in the block and the delay time that stems from the crossover between blocks. In this case, the delay time could be reduced to about one-third that of the conventional example. When GaAs is used, furthermore, the number of defects to be repaired increases by 5 times in the above-mentioned example into an average of 25. If a single computer uses 10 blocks, it would be very easy to repair 25 defects per each block.

## Embodiment 1

An embodiment will now be described in conjunction with the drawings.

Fig. 1 is a plan view for explaining the wafer scale integrated circuit according to the present embodiment, wherein reference numeral 1 denotes a silicon water which is 5 inches in diameter and 0.5 mm in thickness, reference numeral 2 denotes functional blocks in which, for example, symbol A represents an arithmetic unit of a large computer or the like and B denotes an instruction controller. Both of them have sizes of greater than 10 cm$^2$ and more than about 100,000 gates. As will be understood from the aforementioned equation (3), the yield of the individual blocks before being repaired is very small. Reference numeral 3 denotes defects. According to this embodiment, the defects 3 are detected for their positions and are all repaired by a method that will be described later. Reference numeral 5 denotes a wiring for connecting input-output terminals 4 of the functional blocks 2. In this embodiment, the functional blocks 2 are formed on the silicon wafers 1 by a known process for manufacturing semiconductors. The wirings 5 are also formed by the process for manufacturing semiconductors, and are made up of thin film wirings such as of aluminum. As described earlier, according to this embodiment, the total wiring length of the mutual wirings 5 among the functional blocks can be greatly reduced compared with that of the conventional wafer integrated circuit. Therefore, the total number of wiring layers required for forming the wirings 5 can be decreased to enhance reliability of the mutual wirings.

As shown in Fig. 1, the wafer scale integrated circuit according to this embodiment is comprised of seven functional blocks 2 whose macro functions have not been logically divided, and the silicon wafer that serves as a wiring substrate has a side of a length L of about 9 cm. That is, the values B, L in the equations (1) and (2) can be set to be 7 and 9 cm, respectively. Further, the constants a, r can be set to be 2 and 2/3, respectively, as described earlier. In the functional blocks in which the macro functions are not logically divided of this embodiment, furthermore, there does not hold Rent's rule that is expressed by the equation (1). In this embodiment, the number P of the input-output terminals is about 1000. From the equation (2), therefore, the total wiring length W of the wafer scale integrated circuit of the embodiment is about 120 meters.

As shown in Fig. 1, the above-mentioned seven functional blocks 2 have sizes of about 10 cm$^2$, though they differ slightly from each other, and have a gate number G of about 100,000.

Further, the average defect density $\lambda$ is about 1/cm$^2$. By substituting $\lambda$ = 1/cm$^2$ and A = 10 cm$^2$ in the equation (3), therefore, the yield $\eta$ of one functional block 2 before being repaired is smaller than 1%.

A conventional integrated circuit that corresponds to the wafer scale integrated circuit with 700,000 gates for a large computer shown in Fig. 1, has heretofore been constituted by functional blocks with 10,000 gates. Therefore, the number B of blocks on the wiring substrate of silicon wafer becomes 70. By substituting a = 2, r = 2/3 and G = 10,000 for the equation (1), furthermore, the number P of input-output signal terminals of one functional block becomes 928. If L = 9 cm and N = 3 like in this embodiment, furthermore, it will be recognized from the equation (2) that the total wiring length W of the wafer scale integrated circuit according to the prior art is about 960 meters.

The wiring length that can be accommodated by one wiring layer is about 100 meters. In the case of this embodiment in which the total wiring length is about 120 m, therefore, two layers are required since 120 m/100 m = 1.2. In the case of the prior art in which the total wiring length is about 960 meters, ten layers are required since 960 m/100 m = 9.6.

As will be described later, the defects are repaired by substituting an element such as a defective transistor by a good element. It is further allowable to replace a defective portion by a good gate or a circuit group of a very small scale. By sufficiently decreasing the size of a unit for substitution, the yield of units can be brought to almost 100%. According to the equation (3), for instance, the yield is 37% when the defect density is 1/cm$^2$ and the square block has a side of 1 cm, and the yield is 99.99% when the square block has a side of 100 $\mu$m. Therefore, when a large chip is to be fabricated by repairing the defects with the square of 1 cm as a unit at one time, it is necessary to provide square units of a size of 1 cm in a number three times as great as should be attached, like in the aforementioned monolithic wafer scale integrated circuit. However, when the defects are to be repaired with the square of a size of 100 $\mu$m as a unit, then the extra square units of a size of 100 $\mu$m need be formed, on the average, in a number of 0.01%. In practice, the units for repair need be formed in a number 10% greater than the required number by taking into consideration the fact that the units for repair are better provided in several kinds and that the defective ones are better replaced by good ones located as close thereto as possible. From the level of the transistor, therefore, the size of units to be replaced constitutes a circuit group of a size that can be obtained maintaining the yield of about 95%. This scale represents a size of about 2 mm if the defect density is 1/cm$^2$ and represents a size of 900 $\mu$m square if the defect density is 5/cm$^2$.

By repairing the defects as described above, therefore, it is made possible to obtain functional blocks of a very large scale employing high-speed elements such as of silicon or GaAs without almost decreasing the mounting density (gate density).

Embodiment 2

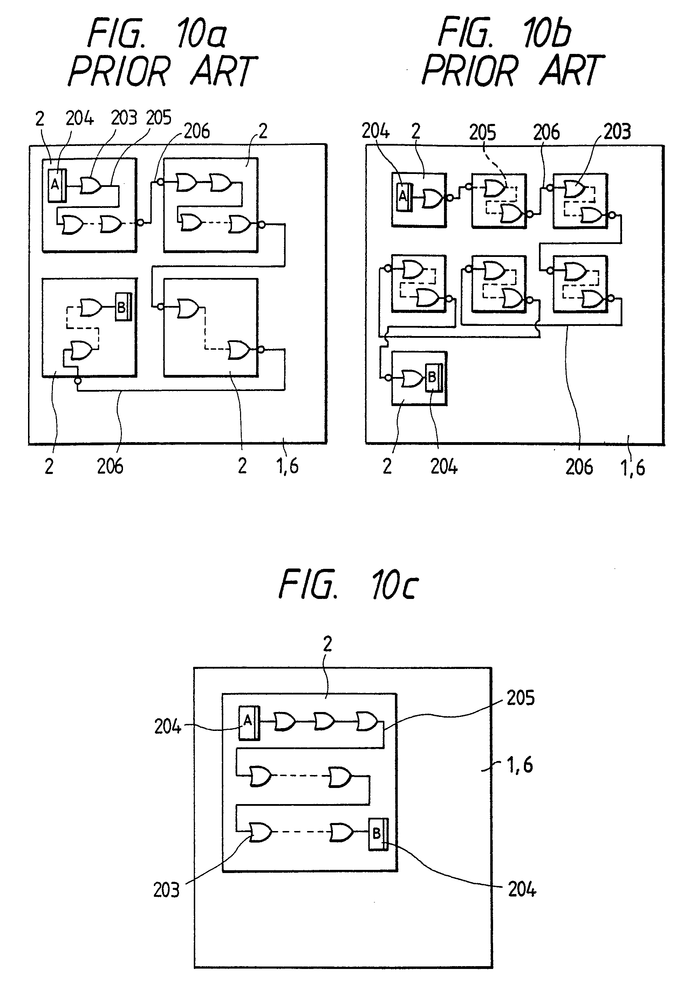

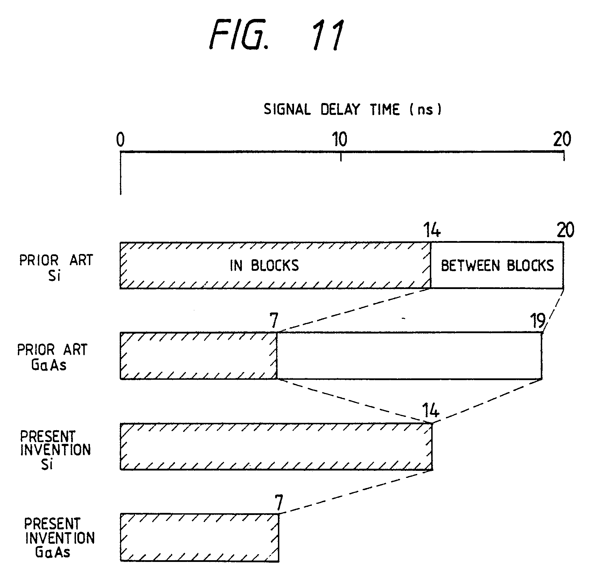

Next, the signal delay time according to the present invention will be compared with the signal delay time according to the conventional art in conjunction with Figs. 10a to 10c and Fig. 11. In Figs. 10a to 10c, reference numerals 1, 6 denote wafers or substrates, 2 denotes a block, 204 denotes a latch, 203 denotes a gate, and 205 denotes a wiring which connects the latch 204 and the gate 203 together in the block. Reference numeral 206 denotes a wiring for connecting the blocks and other blocks. A signal sent from a latch A reaches a latch B via 20 gates 203. The machine cycle time of the electronic computer is determined by the signal delay time on the signal path. Therefore, a high-speed computer which features short calculation time can be realized as the delay time through the signal path decreases. Figs. 10a and 10b illustrate prior art, and Fig. 10c illustrate the art according to the present invention.

Fig. 10a illustrates the case of prior art using a silicon semiconductor and in which the signal path is constituted chiefly by four blocks 2. The blocks have a size of 1 cm x 1 cm and a scale of 10,000 gates. The signal path crosses over the blocks three times. The signal delay time in the blocks. is 14 ns, and the signal delay time for crossing over among the blocks is 6 ns. Therefore, the signal delay time throughout the whole path is 20 ns.

Fig. 10b illustrates the case of prior art using a gallium-arsenic (GaAs) semiconductor, and in which the signal path is constituted chiefly by seven blocks 2. As mentioned earlier, GaAs has a defect density greater than that of silicon. To obtain a yield similar to that of the functional block of silicon, therefore, it is required to reduce the scale of the block. Therefore, the signal path crosses over the blocks six times as shown in Fig. 10b. When GaAs is used, the signal delay time in the block is halved compared with that of when silicon is used, i.e., is reduced to 7 ns. Compared with when silicon is used, however, the signal path crosses over the blocks a doubled number of times. Therefore, the signal delay time for crossing over among the blocks becomes 12 ns which is twice as long as that of when silicon is used. Namely, the signal delay time is 19 ns throughout the whole path, and the high-speed operation is not realized compared with when silicon is used.

The relationship between the integration level of blocks and the number of stages of gates in the block was mentioned earlier. According to this relationship, the number of stages of gates is doubled even when the integration level increases by five times from 2000 gates to 10000 gates, and the number of times of cross over becomes one-half. This is because one unity of logic expands to several tens of thousands of gates. When the integration level reaches about 50,000 gates as shown in Fig. 10c, the whole signal path is contained in one block. Further, the four blocks 2 shown in Fig. 10a include logics of those blocks that are not encompassed by seven blocks 2 shown in Fig. 10b.

Fig. 10c illustrates an example where the present invention is adapted to both of the cases of a macro functional block using silicon and a macro functional block using GaAs. The block 2 encompasses the entire signal path. Since there exists no wiring for crossing over the blocks, the signal delay time is 14 ns in the case of silicon and is 7 ns in the case of GaAs, which is one-half that of the former case. Other blocks are not diagramed in Figs. 10a to 10c.

The conditions of a signal delay times of these cases are shown in Fig. 11. This embodiment does not involve signal delay time among the blocks, and the signals are transferred at high speeds owing to the reduction in the signal delay time. When GaAs is used, in particular, the signal delay time can be reduced to about one-third compared with that of the conventional system which uses silicon.

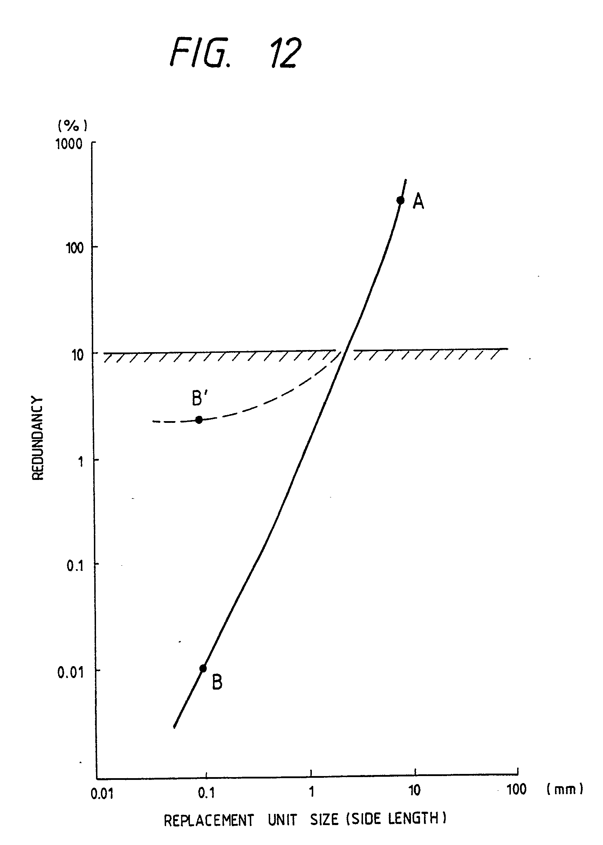

Fig. 12 is a graph for explaining a relationship between the replacement unit and the redundancy in the case when the defect density is $1/cm^2$. As mentioned earlier, the yield becomes 37% when a side of the replacement unit has a length of as long as 10 mm. To obtain the device of good quality using the monolithic wafer scale integrated circuit maintaining such a replacement unit, therefore, it is necessary to provide three blocks. That is, the redundancy becomes 300% (see point A in Fig. 12). On the other hand, if the replacement unit is 100 μm (0.1 mm), the yield thereof becomes 99.99% or higher. Namely, the replacement units may be provided at a rate of one unit per a square centimeter. Therefore, the redundancy is about 0.01% (see point B in Fig. 12). A solid line in Fig. 12 represents a curve that is directly derived from the above-mentioned relationship between the redundancy and the yield. On the other hand, a broken line in Fig. 12 represents the case where the replacement units are provided in a plurality of types or where the replacement units are formed in a number of more than one per square centimer in order to shorten the distance between the replacement unit and a portion to be repaired as much as possible. Even in this case, the redundancy is suppressed to be smaller than 10% (see point B' in Fig. 12).

Embodiment 3

This embodiment is concerned with repairing the wafer scale integrated circuit discussed in the embodiment 1.

Figs. 4a and 4b are schematic diagrams for explaining the repairing method according to this embodiment.

Fig. 4a is a diagram illustrating the state of before being repaired, and wherein reference numeral 12 denotes an element such as a transistor or the like, and reference numerals 10 and 14 denote wirings. Reference numeral 13 denotes a defect, i.e., breakage in the wiring 10. Reference numeral 15 denotes a short-circuited portion between the wirings 10 and 14, which is a defect, too. Reference numeral 16 denotes a spare element. It is presumed here that the element 12 fails to properly operate due to crystal defect in the semiconductor. Fig. 4b illustrates the state after Fig. 4a is repaired, and wherein reference numeral 20 denotes a rewiring, 21 denotes connection points, and 18 denotes a cut portion. The breakage 13 in the wire is repaired by the rewiring 20. The short-circuited portion 15 is repaired by cutting the wiring as designated at 18. The element 12 is separated away by the cutting 18 at three portions, and the spare element 16 is connected through connection wirings 19.

Fig. 5 is a diagram for explaining an example of a method of inspecting and repairing the functional blocks, wherein reference numeral 1 denotes the cross section of the silicon wafer 1 explained in Fig. 1, and 100 denotes a plurality of probes for inspecting the central functional block 2. The tip of the probe is brought into contact with the input-output terminals at the periphery of the functional block and with the terminals for measuring. A signal for inspection is inputted to the functional block 2 from the probe 100, and an output signal thereof is detected. Owing to the inspection by the probe, position of the defect 3 is roughly indicated. For example, owing to the inspection using probes, the position of defect is pointed out with a circuit which finds AND or OR of input signals as a unit, i.e., with a so-called gate circuit as a unit, such a circuit being constituted by 5 to 6 transistor elements.

Next, using an electron beam 101, the position of the defect 3 is correctly pointed out by searching the vicinity of the defect 3 of which the position was roughly pointed out in the previous time. The electron beam 101 is emitted from a widely known electron beam testing apparatus. The tip of the electron beam is smaller than 1 μm in diameter which is much smaller than the tip of the probe 100. The defect 3 is then repaired, i.e., cut, connected and is exchanged by using an ion beam milling machine or a laser CVD (Chemical Vapor Deposition) apparatus. Reference numerals 102 and 103 denote tips of ion beam or laser beam emitted from the ion beam milling machine or the laser CVD apparatus. Thus, the defects 3 in the functional blocks are pointed out for their positions and are repaired.

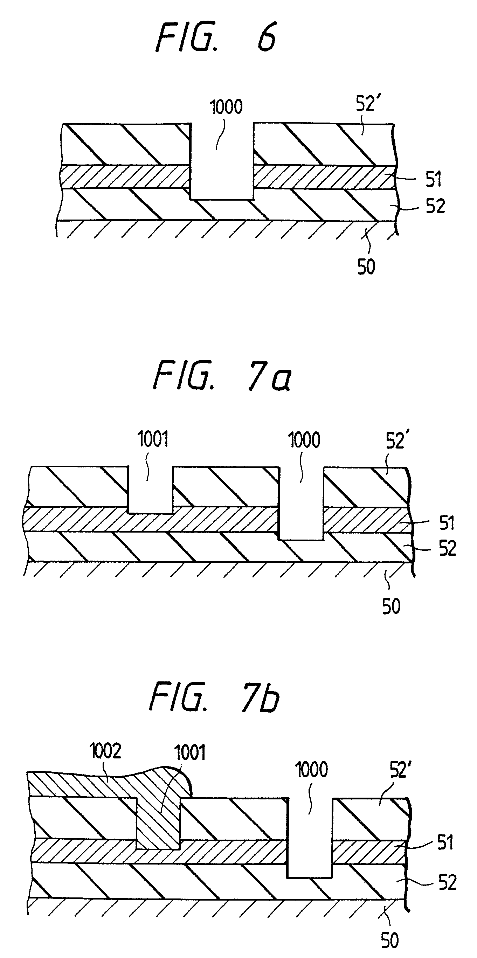

Fig. 6 is a diagram for explaning an example of the cross section of a wiring that is cut for repairing, wherein reference numeral 51 denotes a wiring such as of aluminum which is formed on a silicon semiconductor wafer or a chip substrate 50 being sandwitched between insulating layers 52 and 52' which may be composed, for example, of silicon oxide. For easy explanation, Fig. 6 shows the wiring 51 in a single layer which, however, may be in the form of a multi-layer. The layers 51, 52 and 52' have thicknesses of about 1 to 2 μm. Reference numeral 1000 denotes a hole formed using, for example, the ion beam milling machine, and has a diameter of about 3 μm. The wiring 51 is cut by the hole 1000 for cutting.

Figs. 7a and 7b are diagrams for explaining the cross section of the wiring that is repaired according to the embodiment, and wherein the sizes are nearly equal to those of Fig. 6. Fig. 7a is a diagram illustrating the state after the hole 1001 for connection and the hole 1000 for cutting are formed. The wiring 51 is cut by the hole 1000. Fig. 7b is a diagram illustrating the state after the wiring for reconnection or rewiring 1002 is formed. The additional wiring 1002 is composed of, for example, tungsten or molybdenum and is formed using an ion beam or a laser CVD. The wiring 51 is thus reconnected or is rewired by the additional wiring 1002 which is electrically connected.

According to this embodiment, defects in the functional blocks are repaired and, hence, the yield is almost 100%.

On the other hand, when the device same as that of this embodiment is fabricated according to the prior art which does not repair the functional blocks, the yield is almost 0%. According to the prior art, therefore, the functional blocks are finely divided by the partition of logic to enhance the yield to about 30%. In the case of the conventional monolithic wafer scale integrated circuit, the functional blocks in which logics are divided, must be provided in a plurality of numbers, i.e., must be provided redundantly.

Embodiment 4:

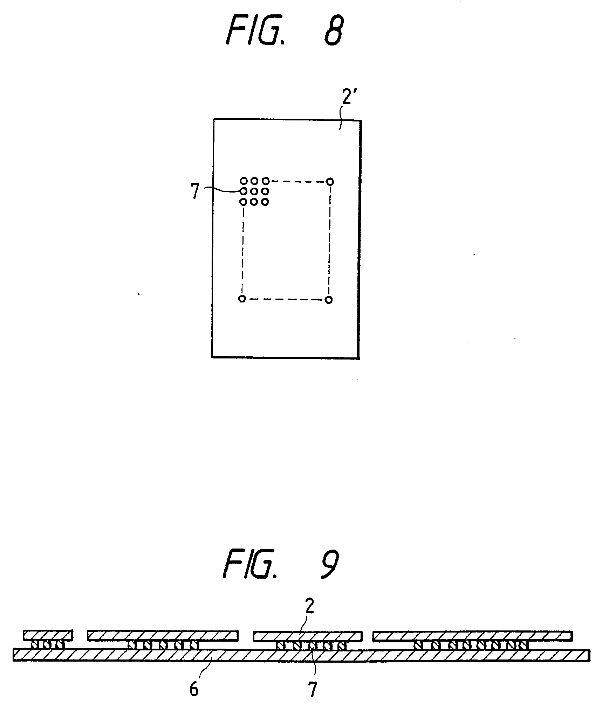

According to the aforementioned embodiments shown in Fig. 1 etc., the wafer scale integrated circuit according to the present invention was realized relying upon the monolithic technology. Described below in conjunction with Figs. 8 and 9 is a further embodiment of the invention in which the wafer scale integrated circuit is realized based upon the hybrid technology. Fig. 8 is a plan view of a functional block 2' which is individually cut out from the wafer. Defects have already been repaired by the method explained in conjunction with Figs. 4a to 7b before the functional block 2' is cut out from the wafer. Reference numeral 7 denotes input-output signal terminals and power source terminals which are composed of solder bumps that pertain to widely known connection technology. Fig. 9 is a section view illustrating the state where the individual functional blocks 2' are mounted on the wafer wiring substrate 6 using solder bumps 7. As mentioned earlier, the total number of wiring layers in the substrate 6 is small, making it possible to improve reliability among the mutual wirings. When the number of functional blocks 2' is small, the total number of mutual wirings is not so great in the substrate 6. Therefore, the substrate 6 needs not necessarily be the wafer wiring substrate but may be a conventional multi-layer ceramic substrate.

In the aforementioned drawings, the same numerals represent substantially the same portions.

According to the wafer scale integrated circuit of the present invention, use is made of functional blocks having large areas obtained by repairing and whereby it is made possible to shorten the total wiring length among the blocks to simplify the complex wiring process required by the wafer scale integrated circuit. Furthermore, the total number of wiring layers is reduced to shorten the signal propagation delay time and to obtain a high packaging density with small redundancy. Therefore, the wafer scale integrated circuit can be very highly densely packaged maintaining high reliability in such applications as data and communication equipment. In the wafer scale integrated circuit of the present invention, furthermore, the defects in the functional block are repaired and the yield can be increased up to nearly 100%. Namely, the invention can be adapted to the wafers which may have any large size. Therefore, the yield of functional blocks does not impose any substantial upper limit on the scale of the wafer scale integrated circuit, enabling the scale to be strikingly increased over those of the prior art.

## Claims

1. A wafer scale integrated circuit comprising a plurality of functional blocks (2, 2'), wherein at least one of said blocks has its internal defects(3) repaired and has such a scale that is obtained maintaining a practicable yield only after repairing the block.

2. A wafer scale integrated circuit according to claim 1, wherein said practicable yield is greater than 10%.

9

3. A wafer scale integrated circuit according to claim 1, wherein said wafer scale integrated circuit is of the monolithic type in which said plurality of functional blocks (2) are formed on a single semiconductor wafer (1).

4. A wafer scale integrated circuit according to claim 1, wherein said wafer scale integrated circuit is of the hybrid type in which said plurality of functional blocks are formed as individual semiconductor chips (2'), and these chips are connected to a semiconductor wafer(6) that serves as a wiring substrate.

5. A wafer scale integrated circuit comprising a plurality of functional blocks (2, 2') formed on a semiconductor wafer(1, 6),wherein at least one of said blocks has its internal defects (3) repaired and has an area of at least 2.3 cm².

6. A wafer scale integrated circuit according to claim 5, wherein said wafer scale integrated circuit is of the monolithic type in which said plurality of functional blocks (2) are formed on a single semiconductor wafer (1).

7. A wafer scale integrated circuit according to claim 5, wherein said plurality of functional blocks are formed as individual semiconductor chips (2'), and said chips are connected to a semiconductor wafer (6') that serves as a wiring substrate.

8. A wafer scale integrated circuit comprising a plurality of functional blocks (2, 2') that are formed on a semiconductor wafer (1, 6) and that are electrically connected to at least one another, wherein at least one of said blocks i) has a cut portion in the wiring (51) that is provided between insulating layers (52) and (52'), and/or ii) has an additional wiring portion (1002) that connects to said wiring (51) via a hole (1001)in the insulating layer (52') on the wiring (51) that is provided between said insulating layers (52) and (52'), and said at least one block has an area of greater than or equal to 2.3 cm².

9. A wafer scale integrated circuit according to claim 8, wherein an element (12) whose wiring is broken exists in said at least one block.

10. A wafer scale integrated circuit according to claim 8, wherein said wafer scale integrated circuit is of the monolithic type in which said plurality of functional blocks (2) are formed on a single semiconductor wafer (1).

11. A wafer scale integrated circuit according to claim 8, wherein said plurality of functional blocks are formed as individual semiconductor chips (2'), which are connected to a semiconductor wafer (6) that serves as a wiring substrate.

12. A wafer scale integrated circuit according to claim 8, wherein said at least one functional block has an area that is larger than or equal to 5 cm².

13. A wafer scale integrated circuit according to claim 8, wherein said at least one functional block has an area that is larger than or equal to 10 cm².

FIG. 1

FIG. 2
PRIOR ART

## FIG. 3    PRIOR ART

# FIG. 4a

# FIG. 4b

# FIG. 5

# FIG. 6

1000

52'

51

52

50

# FIG. 7a

1001

1000

52'

51

52

50

# FIG. 7b

1002

1001

1000

52'

51

52

50

## FIG. 8

## FIG. 9

# FIG. 10a
# PRIOR ART

# FIG. 10b
# PRIOR ART

# FIG. 10c

# FIG. 11

SIGNAL DELAY TIME ( ns )

# FIG. 12